# EUROPÄISCHE PATENTSCHRIFT

(11) **EP 0 570 840 B1**
(45) Veröffentlichungstag und Bekanntmachung des Hinweises auf die Patenterteilung: **03.09.1997**
(21) Anmeldenummer: 93107785.3
(22) Anmeldetag: 13.05.1993
(51) Int. Cl.: G01R 1/067

(54) **Tastkopf zur Überprüfung elektrischer Schaltungen**
Sensor for testing integrated circuits
Sonde pour tester des circuits intégrés

(30) Priorität: 16.05.1992 DE 4216261
(43) Veröffentlichungstag der Anmeldung: 24.11.1993
(73) Patentinhaber: PMK MESS- UND KOMMUNIKATIONSTECHNIK GmbH, W-6056 Heusenstamm (DE)
(72) Erfinder: Heimann, Peter, W-6239 Eppstein (DE); Bespaljko, Slavko, W-6053 Obertshausen (DE); Ridolfi, Martin, W-6451 Mainhausen 2 (DE); Ponkratz, Horst, W-6082 Mörfelden-Walldorf (DE)
(74) Vertreter: Wolf, Günter, Dipl.-Ing.

(56) Entgegenhaltungen:
- EP-A- 0 461 391
- FR-A- 2 365 805
- US-A- 2 790 144
- US-A- 4 418 314

## Beschreibung

Die Erfindung betrifft einen Tastkopf zur Überprüfung elektrischer Schaltungen gemäß Oberbegriff des Patentanspruches 1.

Derartige Tastköpfe sind bspw. nach der US-A-4,418,314 bekannt, bei deren Gegenstand es sich allerdings um einen Hochspannungstastkopf handelt. Solche Tastköpfe bestehen im wesentlichen aus einem nichtleitenden Griff mit einer ein Isolierstück durchgreifenden Tastspitze, zwischen deren Anschlußstück und einem Kabelanschlußstück auf einer Leiterplatte mindestens ein Teilerwiderstand, eine Dämpfungsdrossel und im Bereich des Griffes ein Kapazitätstrimmer innerhalb eines rohrförmigen, sich durch den Griff erstreckenden, rohrförmigen Masseleiters angeordnet sind, wobei im Griff achsmittig gehalten, die Leiterplatte für den mindestens einen Teilerwiderstand, die Dämpfungsdrossel und den Kapazitätstrimmer angeordnet ist und wobei sich die Tastspitze, die Anschlußstücke und die Leiterplatte mit ihrer Längsmittellinie in der gemeinsamen Längsachse von Griff und Isolierstück erstrecken und wobei ferner das in bezug auf den Innendurchmesser des Masseleiters wesentlich durchmesserkleinere Anschlußstück zwischen innerem Tastspitzenende und Leiterplatte angeordnet ist.

Tastköpfe dieser Art enthalten bei festem Teilerverhältnis axiale Widerstände, die freitragend oder mit anderen elektrischen Bauelementen (z.B. Dämpfungsdrossel und Widerstand) auf eine geätzte Leiterplatte aufgebracht und im den ganzen Tastkopf bildenden Griff eingebaut werden. Siehe hierzu den weiteren Stand der Technik gemäß EP-A-0,461,391 (mit Leiterplatte) und US-A-2,912,647, 3,513,388 (ohne Leiterplatte).

Sofern solche Tastköpfe mit Leiterplatten ausgestattet sind, wovon hier ausgegangen wird, muß die Bestückung der Leiterplatte als auch der anschließende Lötvorgang manuell durchgeführt werden. Abgesehen davon, daß bei Tastköpfen mit Leiterplatten deren Erstreckungsbereich in bezug auf den rohrförmigen Masseleiter nicht besonders isoliert ist (siehe US-A-4,418,314 und EP-A-0,461,391) ist es bekannt, zur Isolierung gegenüber dem rohrförmigen Masseleiter die Leiterplatte vor dem Einbau mit einem Isolierschlauch zu überziehen, was zu Beeinträchtigungen der auf der Leiterplatte angeordneten Elemente führen kann.

Der Erfindung liegt die Aufgabe zugrunde, einen Tastkopf der eingangs genannten Art dahingehend zu verbessern, daß sich der Fertigungs- und Montageaufwand und damit die Herstellungskosten wesentlich vereinfachen und reduzieren lassen, und zwar gleichzeitig verbunden mit der Maßgabe, die Funktionssicherheit und die elektrischen Verhältnisse des ganzen Tastkopfes günstiger zu gestalten.

Diese Aufgabe ist mit einem Tastkopf der gattungsgemäßen Art nach der Erfindung durch die Kombination der folgenden Merkmale gelöst:

Der Griff ist aus einem Griffstück und aus einer tastspitzenseitig vorgesetzten, den Masseleiter umgreifenden Isolierhülse gebildet; die im Griffstück angeordnete Leiterplatte ist als doppelseitiger Träger für die Stromleitpfade, Teilerwiderstände, Dämpfungsdrosseln und von außen betätigbare Kapazitätstrimmer in Hybridbauweise ausgebildet und in einem aus zwei halbzylindrischen Schalen gebildeten Isolierrohr angeordnet; das von der Leiterplatte zur Tastspitze führende Anschlußstück ist innerhalb eines rohrförmigen Isolierstückes mit dem inneren Tastspitzenende mindestens mit Berührungskontakt verbunden und ein Schalter für die Umschaltung der Teilerwiderstände ist in Form eines auf der Leiterplatte angeordneten Reedschalters ausgebildet, dem außen am Griffstück ein Stellschieber zugeordnet ist.

Bei dieser Lösung sind also gezielt alle genannten Elemente und die diese tragende Leiterplatte in das mehr Raum bietende Griffstück verlegt, und zwar mit der elektrisch vorteilhaften Folge einer weitgehend koaxialen Anordnung, wobei sich in der vorderen Isolierhülse ausschließlich das dünne Anschlußstück koaxial erstreckt, und zwar unter Ausbildung eines trotzdem relativ großen, ringzylindrischen Raumes als verbessertes Dielektrikum. Durch die absolut plane, doppelseitig bestückbare, in ihrer Länge auf den verfügbaren Raum im Griffstück beschränkte und einen Hybridbaustein bildende Leiterplatte läßt sich auch das Ganze wesentlich rationeller herstellen und montieren, und zwar einschließlich einer die Hybridleiterplatte umschließenden Spannungsdurchschläge verhindernden Isolierung, die aus zwei halbzylindrischen Schale gebildet ist, mit denen einfach die Leiterplatte mit den daran angeordneten Elementen umschlossen wird. Der Zusammenhalt der Halbschalen ergibt sich dabei automatisch nach Einschub in den rohrförmigen Masseleiter. Ganz wesentlich ist dabei auch, daß für den Teilerverhältnisumschalter ein sogenannter Reed-Schalter benutzt wird, welcher Schalter heute bereits in geeigneter Kleinstbauweise handelsverfügbar und der Hybridbauweise zugänglich sind. Zur berührungslosen Betätigung eines solchen Schalters ist über diesen in einem Schlitz des Griffstückes ein mit einem Klein-Magneten bestückter Schieber geführt, der mindestens das Isolierrohr in einem entsprechenden Schlitz durchgreift. Wenn der Masseleiter bspw. aus Messing besteht, muß dieser keinen Schlitz aufweisen, da der Magnet auch durch einen solchen Masseleiter hindurch wirksam wird. Dieser Reed-Schalter ist also Teil der Leiterplatte, wird von den halbzylindrischen Schalen mit umschlossen und kann somit komplett mit diesen zusammen in den im Bereich des Griffstückes sich erstreckenden Teil des rohrförmigen Masseleiters eingeschoben werden. Gleiches gilt auch für den Kapazitätstrimmer, der ebenfalls Bauteil der Hybridleiterplatte ist. In weiterer Ausgestaltung ist dieser dafür mit einem aufsteckbaren, eine Verrastungsschulter aufweisenden Stellstück versehen und die Verrastungsschulter am inneren Umfang einer Einstecköffnung am Griff verrastet, welcher Einstecköffnung durchmessergrößere Durchgriffsöffnungen am Masseleiter und am Isolierrohr fluchtend zugeordnet sind. Einerseits steht dadurch einem komplikationslosen Einschub nichts im Wege, da das Stellstück erst nach dem Einschub eingesetzt wird und andererseits ist das sonst übliche und Verschmutzungen zugängliche Loch im Tastkopfgriff durch das Stellstück verschlossen.

Ohne etwas an der Gesamtkonzeption ändern zu müssen, kann der Tastkopf mit einer starren oder einer elastisch axial verschieblichen Tastspitze ausgerüstet werden, womit im letzteren Fall sehr feinfühlig an eine Abgriffsstelle einer zu überprüfenden Schaltung herangegangen werden kann.

Bei der bisher angewandten Technik (siehe US-A-4,418,314 und EP-A-0,461,391) wurde zur Verminderung der Eingangskapazität zwischen dem Innenleiter und dem Außenleiter die Leiterplatte mit ihren elektrischen Bauteilen sich möglichst bis zur Tastkopfspitze hin erstreckend ausgebildet und angeordnet. Nachteilig sind dabei die sich bildenden Kapazitäten zwischen den Bauteiloberflächen und dem Masseleiter, wodurch die Grenzfrequenz einer solchen Anordnung vermindert wird. Beim erfindungsgemäßen Tastkopf liegt demgegenüber eine HF-günstigere Koaxialanordnung von Innen- und Außenleiter in der Isolierhülse vor, während die parasitären Kapazitäten der Bauteile durch konsequentes Verlegen in das einen größeren Innenraum aufweisende Griffstück HF-technisch geringer gehalten werden können, so daß damit höhere Grenzfrequenzen gegeben sind.

Die erfindungsgemäße Ausbildung der Leiterplatte als Hybridbaustein hat nicht nur Fertigungs- und Montagevorteile, sondern auch HF-technisch ergeben sich aufgrund des Trägermaterials (Keramik) und der damit verbundenen geringeren Raumbeanspruchung ebenfalls höhere Grenzfrequenzen.

Der erfindungsgemäße Tastkopf wird nachfolgend anhand der zeichnerischen Darstellung von Ausführungsbeispielen näher erläutert.

Es zeigt schematisch und stark vergrößert
- Fig. 1: einen Längsschnitt durch den erfindungsgemäßen Tastkopf;
- Fig. 2A-C: die elektrischen "Innereien" mit Leiterplatte in drei Ansichten;
- Fig. 3A-C: eine entsprechende Darstellung gemäß Fig. 2 in anderer Ausführungsform;
- Fig. 4: die Schaltung zu Fig. 2 und
- Fig. 5: eine andere Ausführungsform der Schaltung.

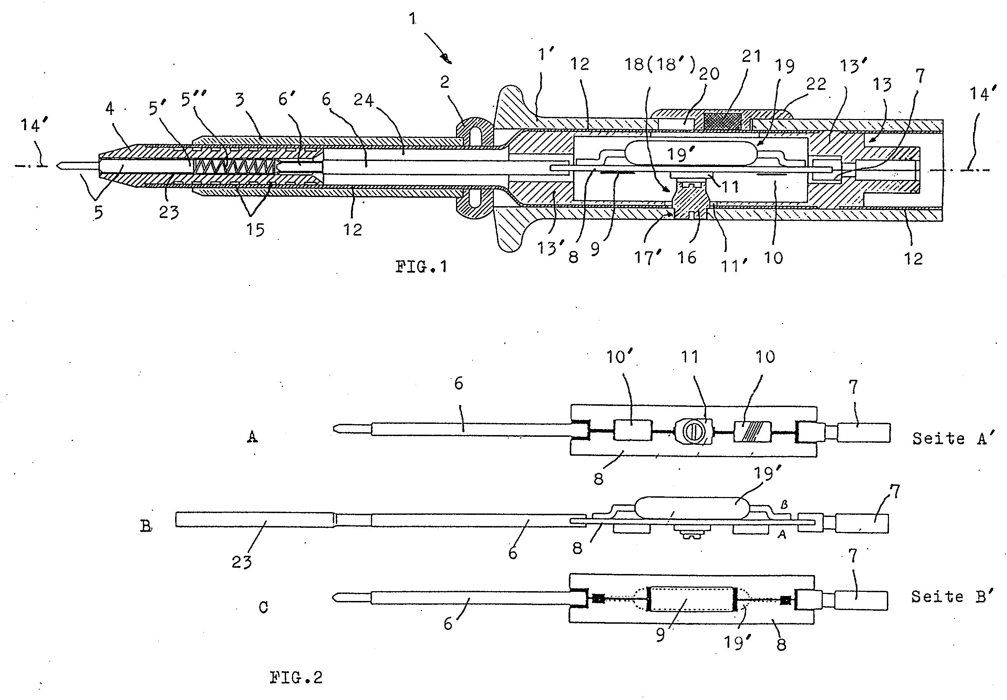

Wie aus Fig. 1 ersichtlich, besteht der Tastkopf in bekannter Weise aus einem nichtleitenden Griff 1 mit einer ein Isolierstück 4 durchgreifenden Tastspitze 5, zwischen deren Anschlußstück 6 und einem Kabelanschlußstück 7 auf einer Leiterplatte 8 mindestens ein Teilerwiderstand 9, eine Dämpfungsdrossel 10 und im Bereich des Griffes 1 ein Kapazitätstrimmer 11 innerhalb eines rohrförmigen, sich durch den Griff 1 erstreckenden, rohrförmigen Masseleiters 12 angeordnet sind, wobei im Griff 1, achsmittig gehalten, die Leiterplatte 8 für den mindestens einen Teilerwiderstand 9, die Dämpfungsdrossel 10 und den Kapazitätstrimmer 11 angeordnet ist und wobei sich die Tastspitze 5, die Anschlußstücke 6, 7 und die Leiterplatte 8 mit ihrer Längsmittellinie 14 in der gemeinsamen Längsachse 14' von Griff 1 und Isolierstück 4 erstrecken und wobei ferner das in bezug auf den Innendurchmesser des Masseleiters 12 wesentlich durchmesserkleinere Anschlußstück 6 zwischen innerem Tastspitzenende 5' und Leiterplatte 8 angeordnet ist.

Für einen solchen Tastkopf ist nun Folgendes wesentlich: Der Griff 1 ist aus einem Griffstück 1' und aus einer tastspitzenseitig vorgesetzten, den Masseleiter 12 umgreifenden Isolierhülse 3 gebildet und die im Griffstück 1' angeordnete Leiterplatte 8 ist als doppelseitiger Träger für die Stromleitpfade, Teilerwiderstände 9, Dämpfungsdrosseln 10 und von außen betätigbare Kapazitätstrimmer 11 in Hybridbauweise ausgebildet und in einem aus zwei halbzylindrischen Schalen 13' gebildeten Isolierrohr 13 angeordnet. Das von der Leiterplatte 8 zur Tastspitze 5 führende Anschlußstück 6 ist innerhalb eines rohrförmigen Isolierstückes 4 mit dem inneren Tastspitzenende 5' mit Berührungskontakt verbunden und ein Umschalter 19 für die Teilerwiderstände 9 ist in Form eines Reedschalters 19' ausgebildet, dem außen am Griffstück 1' ein Stellschieber 22 zugeordnet ist.

Alle in Fig. 1 bis 5 dargestellten Ausführungsformen sind für umschaltbare Teilerverhältnisse verdeutlicht, also mit Teilerverhältnisumschaltern 19 in Form von Reed-Schaltern 19' ausgestattet.

Nicht besonders dargestellt ist die geteilte Ausführungsform des die Leiterplatte 8 umschließenden Isolierrohres 13 in Form zweier halbzylindrischer Schalen 13', da ohne weiteres vorstellbar, d.h., die Teilungsebene zwischen den beiden Schalen 13' erstreckt sich senkrecht zur Darstellungsebene und schneidet die Längsmittelachse 14'.

Fig. 1 zeigt im Längsschnitt einen fertig montierten Tastkopf, in den ein komplett montierter Hybrid-Baustein (Leiterplatte 8), eingebettet in die Halbschalen 13' eingesetzt ist. In dem nach außen isolierenden Griffstück 1' sind der Stellschieber 22 mit Magnet 21 für den Reed-Schalter 19' und das isolierende Stellstück 16 für den Kapazitätstrimmer 11 eingerastet montiert. Die an das Anschlußstück 6 befestigte Kontaktklemmhülse 23 wird von dem in die vordere Isolierhülse 3 eingesetzte Isolierstück 4 koaxial gehalten. Der Kapazitätstrimmer 11 ist mit dem aufsteckbaren, eine Verrastungsschulter 11' aufweisenden Stellstück 16 versehen, wobei die Verrastungsschulter 1' am inneren Umfangsrand einer Einstecköffnung 17 am Griff verrastet ist, welcher Einstecköffnung 17 durchmessergrößere Durchgriffsöffnungen 18, 18' am Masseleiter 12 und am Isolierrohr 13 fluchtend zugeordnet sind. Bei fertig montiertem Tastkopf kann also das Stellstück 16 einfach eingedrückt und, wie dargestellt, verrastet werden.

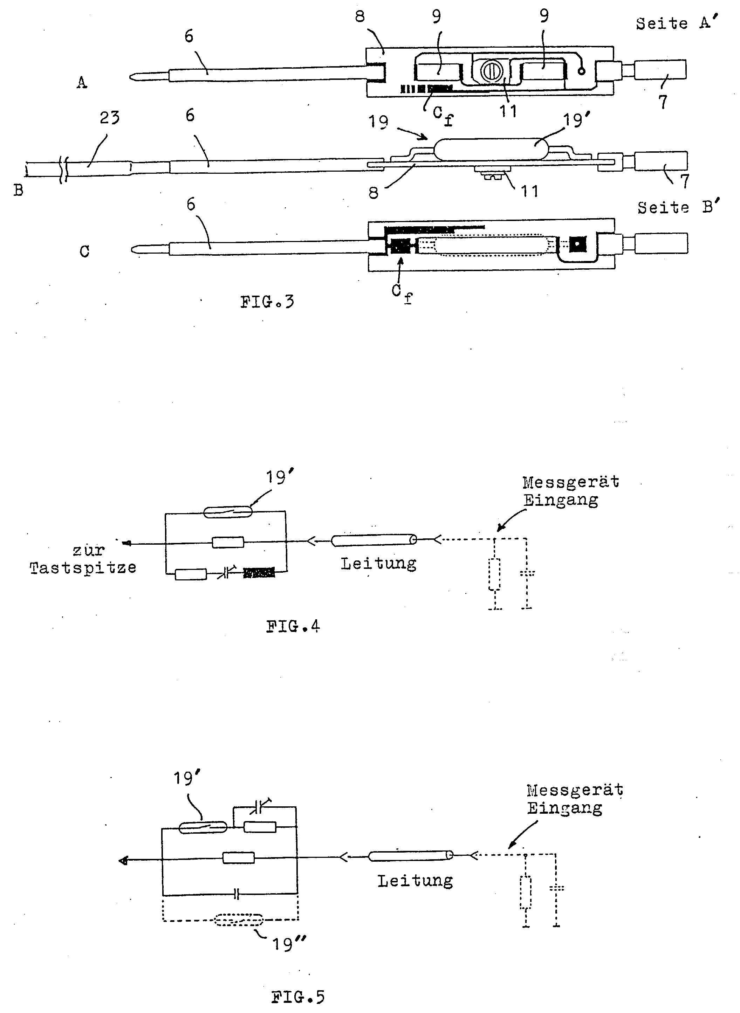

Bei zweiteiliger Ausbildung des Teilerwiderstandes 9 (siehe Fig. 3A) und zwischengeschaltetem Kapazitätstrimmer 11 ist auf der anderen Seite der Leiterplatte 8 ein Teilerverhältnisumschalter 19 in Form eines Reed-Schalters 19' von außen betätigbar im Griffstück 1' angeordnet, zwischen dem und der Isolierhülse 3 ein mit dem rohrförmigen Masseleiter 12 das Massekabelanschlußstück 2 sitzt.

Fig. 2 zeigt den die Leiterplatte 8 bildenden Hybridbaustein, bestückt als umschaltbarer Tastkopfteiler mit einem Teilerverhältnis 1:10 / 1:1 in drei Ansichten. Auf der Seite A' befinden sich die SMD-Bauelemente: Kapazitätstrimmer 11, Dämpfungsdrossel 10 und -widerstand 10' und auf der Seite B': der Teilerwiderstand 9 sowie darüberliegend bei umschaltbarem Teilerverhältnis der Reed-Schalter 19'. Letzterer ist neben den Anschlußstücken 6 und 7 in Seitenansicht voll dargestellt. Durch Anbringen der Kontaktklemmhülse 23 an das Anschlußstück 6 ist der Hybridbaustein montagefertig bestückt. Fig. 3 zeigt den Hybridbaustein, bestückt als umschaltbarer Tastkopfteiler mit einem Teilerverhältnis 1:100 / 1:10 in drei Ansichten. Auf der Seite A' befinden sich aufgebracht die Komponenten für das Teilerverhältnis 1:10 (Kapazitätstrimmer 11 und der zweiteilige Teilerwiderstand 9) sowie der abstimmbare Kapazitätsbelag Cr des unteren Potentials vom rückwärtigen Teilerverhältnis 1:100. Auf der Seite B' sind die Komponenten für das Teilerverhältnis 1:100 aufgebracht (Teilerwiderstand 9 und Kapazitätsbelag Cr des oberen Potentials) sowie darüberliegend bei umschaltbarem Teilerverhältnis der Reed-Schalter 19'. Letzterer ist neben den Anschlußstücken 6 und 7 ebenfalls in Seitenansicht voll dargestellt. Durch Anbringen der Kontaktklemmhülse 23 an das Anschlußstück 6 ist auch hierbei der Hybridbaustein montage fertig bestückt. Alle Strompfade, Widerstände und Kapazitäten sind bei dieser Hybridbauweise in gedruckter Form auf der Leiterplatte 8 aufgebracht, der lediglich der Kapazitätstrimmer und der Reed-Schalter per Lötung zu integrieren sind.

Fig. 4 zeigt das Schaltungsschema eines umschaltbaren Tastkopfteilers 1:10 / 1:1.

| | |
|---|---|
| Schalter geöffnet | Teilung 1:10 |
| Schalter geschlossen | Teilung 1:1 |

Fig. 5 zeigt das Schaltungsschema eines umschaltbaren Tastkopfteilers 1:100 / 1:10, erweiterbar mittels eines zweiten Reed-Schalters 19" auf ein Teilerverhältnis 1:1.

| | |
|---|---|
| Schalter 19' geöffnet | Teilung 1:100 |
| Schalter 19' geschlossen | Teilung 1:10 |
| Schalter 19' geöffnet oder geschlossen, aber Schalter 19" geschlossen | Teilung 1:1 |

Für die Betätigung des Reed-Schalters 19' in Fig. 1 ist über diesem in einem Schlitz 20 des Griffes 1 ein mit einem Klein-Magneten 21 bestückter Schieber 22 geführt. Da der Masseleiter 12 beim Ausführungsbeispiel aus Messing besteht, muß dieser keinen Schlitz aufweisen.

Wie ebenfalls aus Fig. 1 ersichtlich, ist das Anschlußstück 6 zur Tastspitze 5 hin an seinem leiterplattenfernen Ende 6' mit der vorerwähnten Kontaktklemmhülse 23 verbunden und in dieser koaxial im Isolierstück 4 geführten Kontaktklemmhülse 23 ist die Tastspitze 5 stationär oder, wie dargestellt, elastisch axial verschieblich angeordnet.

Zeichnerisch ohne extreme Vergrößerung nicht darstellbar ist die konstruktive Gegebenheit, daß die Tastspitze 5 und die zugehörige Druckfeder 5" gemeinsam in einer in die Kontaktklemmhülse 23 einschiebbaren Hülse sitzen (Fig. 1 entspricht einem Maßstab von etwa 2:1!). Der sich um das dünne Anschlußstück 6 im rohrförmigen Masseleiter 12 ergebende ringzylindrische Freiraum 24 wirkt als verbessertes Dielektrikum und äquivalent wirken auch die Ringnuten 15 am Isolierstück 4.

## Patentansprüche

1. Tastkopf zur Überprüfung elektrischer Schaltungen, bestehend aus einem nichtleitenden Griff (1) mit einer ein Isolierstück (4) durchgreifenden Tastspitze (5), zwischen deren Anschlußstück (6) und einem Kabelanschlußstück (7) auf einer Leiterplatte (8) mindestens ein Teilerwiderstand (9), eine Dämpfungsdrossel (10) und im Bereich des Griffes (1) ein Kapazitätstrimmer (11) innerhalb eines rohrförmigen, sich durch den Griff (1) erstreckenden, rohrförmigen Masseleiters (12) angeordnet sind, wobei im Griff (1), achsmittig gehalten, die Leiterplatte (8) für den mindestens einen Teilerwiderstand (9), die Dämpfungsdrossel (10) und den Kapazitätstrimmer (11) angeordnet ist und wobei sich die Tastspitze (5), die Anschlußstücke (6, 7) und die Leiterplatte (8) mit ihrer Längsmittellinie (14) in der gemeinsamen Längsachse (14') von Griff (1) und Isolierstück (4) erstrecken, und wobei ferner das in bezug auf den Innendurchmesser des Masseleiters (12) wesentlich durchmesserkleinere Anschlußstück (6) zwischen innerem Tastspitzenende (5') und der Leiterplatte (8) angeordnet ist, **gekennzeichnet durch** die Kombination folgender Merkmale:
der Griff (1) ist aus einem Griffstück (1') und aus einer tastspitzenseitig vorgesetzten, den Masseleiter (12) umgreifenden Isolierhülse (3) gebildet; die im Griffstück (1') angeordnete Leiterplatte (8) ist als doppelseitiger Träger für die Stromleitpfade, Teilerwiderstände (9), Dämpfungsdrossel (10) und von außen betätigbare Kapazitätstrimmer (11) in Hybridbauweise ausgebildet und in einem aus zwei halbzylindrischen Schalen (13') gebildeten Isolierrohr (13) angeordnet; das von der Leiterplatte (8) zur Tastspitze (5) führende Anschlußstück (6) ist innerhalb eines rohrförmigen Isolierstückes (4) mit dem inneren Tastspitzenende (5') mindestens mit Berührungskontakt verbunden und ein Umschalter (19) für die Teilerwiderstände (9) ist in Form eines Reed-Schalters (19') ausgebildet, dem außen am Griffstück (1') ein Stellschieber (22) zugeordnet ist.

2. Tastkopf nach Anspruch 1,
**dadurch gekennzeichnet,**
daß zwischen dem Griffstück (1') und der Isolierhülse (3) ein mit dem Masseleiter (12) verbundenes Massekabelanschlußstück (2) angeordnet ist.

3. Tastkopf nach Anspruch 1 oder 2,
**dadurch gekennzeichnet,**
daß der Kapazitätstrimmer (11) mit einem aufsteckbaren, eine Verrastungsschulter (11') aufweisenden Stellstück (16) versehen und die Verrastungsschulter (11') am inneren Umfangsrand einer Einstecköffnung (17) durchmessergrößere Durchgriffsöffnungen (18, 18') am Masseleiter (12) und am Isolierrohr (13) fluchtend zugeordnet sind.

4. Tastkopf nach einem der Ansprüche 1 bis 3,
**dadurch gekennzeichnet,**
daß das am tastkopfseitigen Ende des Masseleiters (12) angeordnete Isolierstück (4) mit äußeren Ringnuten (15) versehen ist.

5. Tastkopf nach einem der Ansprüche 1 bis 4,
**dadurch gekennzeichnet,**
daß bei Anordnung von mehr als zwei Teilerwiderständen (9) für mehr als zwei Teilerverhältnisse zwei Teilerverhältnisumschalter (19) an der Leiterplatte (8) angeordnet sind.

6. Tastkopf nach einem der Ansprüche 1 bis 5,
**dadurch gekennzeichnet,**
daß das Anschlußstück (6) zur Tastspitze (5) an seinem leiterplattenfernen Ende (6') mit einer Kontaktklemmhülse (23) versehen und in dieser koaxial im Isolierstück (4) geführten Kontaktklemmhülse (23) die Tastspitze (5) stationär oder elastisch axial verschieblich angeordnet ist.

## Claims

1. A scanning unit for testing electrical circuits, comprising a handle (1) of a nonconducting material having a scanning tip (5) passing through an insulator (4) wherein are arranged between the connector (6) thereof and a cable connector (7) on a printed circuit board (8), within a tubular mass conductor (12) extending through the handle (1), at least one divider resistor (9), an attenuator (10) and, in the area of the handle (1), a trimming capacitor (11), with the printed circuit board (8) for the at least one divider resistor (9), the attentuator (10) and the trimming capacitor (11) being held within the handle (1) in an axially central manner, and with the scanning tip (5), the connectors (6,7) and the printed circuit board (8) with the longitudinally central line (14) thereof extending within the common longitudinal axis (14') of handle (1) and insulator (4), and with the connector (6) of a substantially smaller diameter than the inside diameter of the mass conductor (12) being arrranged between the inner end (5') of the scanning tip and the printed circuit board (8), characterized by the combination of the following features:
the handle (1) is formed of a handle member (1') and of an insulating sleeve (3) placed ahead of the scanning tip and enclosing the mass condutor (12); the printed circuit board (8) arranged within the handle member (1') is formed as a double-sided carrier for the current conducting paths, divider resistors (9), attenuators (10) and the externally operated trimming capacitor (11) of hybrid construction and is arranged within an insulating tube (13) formed of two semi-cylindrical cups (13'); the connector (6) leading from the printed circuit board (8) to the scanning tip (5), within a tubular insulating element (4), is connected to the inner end (5') ofthe scanning tip at least through tangential contact, and a selector switch (19) for the divider resistors (9) is in the form of a reed switch (19') associated to which, externally on the handle member (1'), is a set slide (22).

2. A scanning unit according to claim 1, characterized in that a mass cable connector (2) connected to the mass conductor (12) is disposed between the handle member (1') and the insulating sleeve (3).

3. A scanning unit according to claims 1 or 2, characterized in that the trimming capacitor (11) is provided with a plug-on set member (16) including a ratchet shoulder (11') and that the ratched shoulder (11'), on the inner peripheral edge of a plug-in opening (17), engages the handle, with passage openings (18,18') of larger diameter on the mass conductor (12) and on the insulating tube (13) being associated in aligning relationship to the said plug-in opening..

4. A scanning unit according to any one of claims 1 to 3, characterized in that the insulator (4) arranged on the end of the mass conductor (12) facing the side of the scanning unit is provided with outer annular grooves (15).

5. A scanning unit according to any one of claims 1 through 4, characterized in that two selector switches (19) for reswitching the divider relationships are arranged on the printed circuit board (8) if more than two divider resistors (9) are arranged for more than two divider relationships.

6. A scanning unit according to any one of claims 1 to 5, characterized in that the connector (6) for connection with the scanning tip (5) at the end (6') facing away from the printed circuit board is provided with a contact terminal sleeve (23) and that the scanning tip is arranged in a manner stationary or resiliently axially displaceable within the said contact terminal sleeve (23) guided in coaxial relationship within the insulator (4).

## Revendications

1. Palpeur pour contrôler les montages électriques constitué par une poignée non conductrice (1) avec une pointe de palpage (5) qui traverse une pièce isolante (4), au moins une résistance séparatrice (9), une inductance d'amortissement (10) étant placées entre la pièce de raccordement (6) de la pointe de palpage et une pièce de raccordement de câble (7) sur une plaquette (8) et dans la zone de la poignée (1) un condensateur de capacité (11) à l'intérieur d'un conducteur à la masse (12) en forme de tuyau qui s'étend à travers la poignée (1), la plaquette (8) pour la résistance séparatrice (9) qui existe au moins, l'inductance d'amortissement (10) et le condensateur de capacité (11) étant placée dans la poignée (1) en se tenant au milieu de l'axe et la pointe de palpage (5), les pièces de raccordement (6, 7) et la plaquette (8) s'étendant avec leur ligne médiane longitudinale (14) dans l'axe longitudinal commun (14') de la poignée (1) et de la pièce isolante (4) et la pièce de raccordement (6) qui a un diamètre beaucoup plus petit que le diamètre inférieur du conducteur à la masse (12) étant placée entre l'extrémité intérieure (5') de la pointe de palpage et la plaquette (8),
caractérisé par la combinaison des caractéristiques suivantes : la poignée (1) est formée par une partie poignée (1') et par une douille isolante (3), placée en avant du côté de la pointe de palpage, qui entoure le conducteur à la masse (12) ; la plaquette (8) qui est placée dans la partie poignée (1') est configurée de type hybride comme un support des deux côtés pour les chemins conducteurs de courant, les résistances séparatrices (9), les inductances d'amortissement (10) et les condensateurs de capacité (11) ) qui peuvent être actionnés de l'extérieur et est placée dans un tuyau isolant (13) formé par deux coques en forme de demi-cylindre (13') ; la pièce de raccordement (6) qui mène de la plaquette (8) à la pointe de palpage (5) est reliée à l'intérieur d'une pièce isolante en forme de tuyau (4) à l'extrémité intérieure (5') de la pointe de palpage au moins par contact et un commutateur (19) pour les résistances séparatrices (9) est configuré en forme de commutateur Reed (19') auquel correspond à l'extérieur sur la partie poignée (1') une vanne de réglage (22).

2. Palpeur selon la revendication 1,
caractérisé en ce
qu'une pièce de raccordement à la masse (2), reliée au conducteur à la masse (12), est placée entre la partie poignée (1') et la douille isolante (3).

3. Palpeur selon la revendication 1 ou 2,
caractérisé en ce
que le condensateur de capacité (11) est pourvu d'une pièce de réglage (16) qui peut être emboîtée, qui présente un épaulement d'enclenchement (11') et l'épaulement d'enclenchement (11') sur le bord périphérique intérieur d'une ouverture d'emboîtement (17) à laquelle correspondent de manière alignée des ouvertures de pénétration (18, 18') de plus grand diamètre sur le conducteur à la masse (12) et sur le tuyau isolant (13).

4. Palpeur selon l'une des revendications 1 à 3,
caractérisé en ce
que la pièce isolante placée à l'extrémité côté du palpeur du conducteur à la masse (12) est équipée de rainures annulaires extérieures (15).

5. Palpeur selon l'une des revendications 1 à 4,
caractérisé en ce
que, pour une disposition de plus de deux résistances séparatrices (9) pour plus de deux rapports de séparation, deux commutateurs de rapports de séparation (19) sont placés sur la plaquette (8).

6. Palpeur selon l'une des revendications 1 à 5,
caractérisé en ce
que la pièce de raccordement (6) avec la pointe de palpage (5) est pourvue à son extrémité (6') éloignée de la plaquette d'une douille de serrage de contact (23) et que la pointe de palpage (5) est placée dans cette douille de serrage de contact (23), guidée axialement dans la pièce isolante (4), de manière stationnaire ou mobile axialement de manière élastique.
